# EUROPEAN PATENT SPECIFICATION

(11) **EP 0 911 678 B1**
(45) Date of publication and mention of the grant of the patent: **10.12.2003**
(21) Application number: 98308666.1
(22) Date of filing: 22.10.1998
(51) Int. Cl.: G02F 1/1333, G02F 1/13

(54) **Display device with terminals connected to a folded film substrate**
Anzeigevorrichtung mit Anschlüssen zur Verbindung mit einem gefalteten Filmsubstrat
Dispositif d'affichage avec contacts connectés à un film substrat replié

(30) Priority: 23.10.1997 JP 29134297
(43) Date of publication of application: 28.04.1999
(73) Proprietor: SEIKO INSTRUMENTS INC., Chiba-shi, Chiba 261 (JP)
(72) Inventor: Matsuhira, Tsutomu, Mihama-ku, Chiba-shi, Chiba (JP); Suginoya, Mitsuru, Mihama-ku, Chiba-shi, Chiba (JP); Aizawa, Takamitsu, Mihama-ku, Chiba-shi, Chiba (JP)
(74) Representative: Sturt, Clifford Mark

(56) References cited:
- US-A- 4 690 510
- US-A- 5 606 440
- US-A- 5 737 053

## Description

The present invention relates to a display device for use in portable equipment, such as an electronic memo device and the like which uses an implement such as pen as an input means.

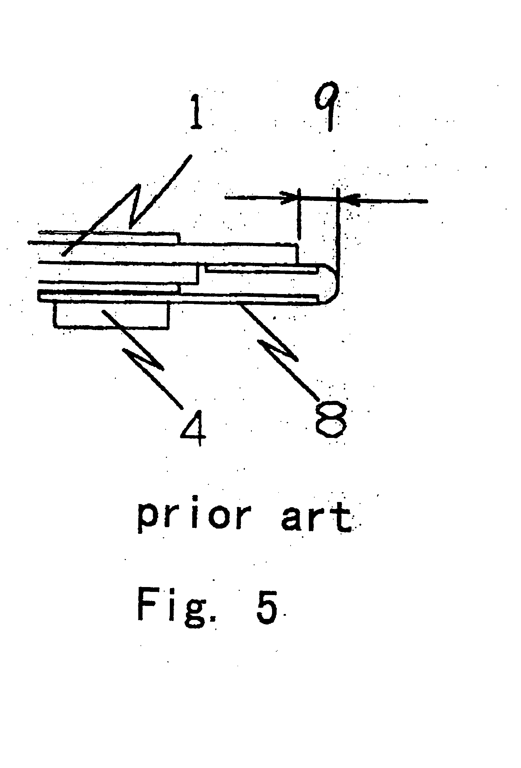

Fig. 5 shows a schematic structure of a conventional display device. As shown in Fig. 5, in a mounting structure of a conventional display device, a film substrate TCP (Tape Carrier Package) 8 provided with a slit for folding is used, and the terminals of a display element 1 are connected with the terminals of the TCP 8. An IC 4 is mounted on the TCP and further the TCP is connected with a circuit substrate such that fabrication is carried out with the TCP folded over and with the circuit substrate located on the rear surface of the display element. As the circuit substrate, a glass epoxy substrate, a polyimide film substrate or the like with chip parts mounted thereon has been used.

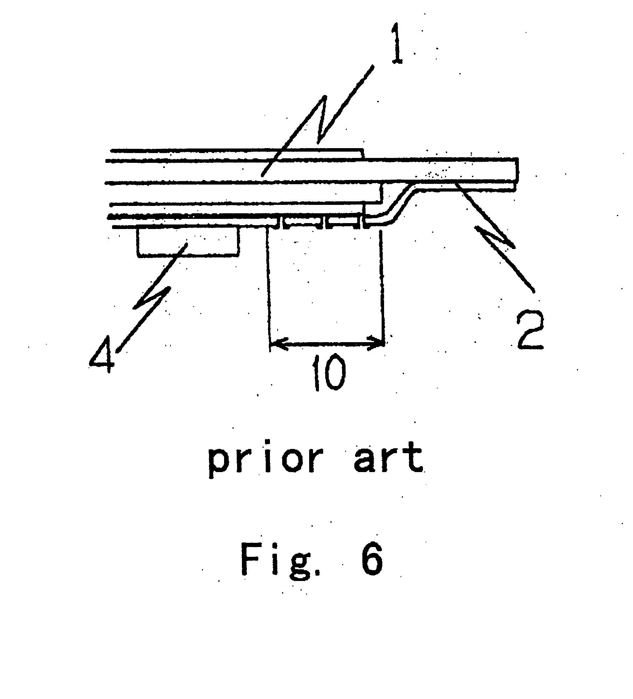

Fig. 6 shows a schematic view of a COF (Chip On FPC) structure with the IC 4 directly mounted on the film substrate 2. In a COF structure, the above-mentioned TCP circuit and the circuit of the circuit substrate are formed on a single film substrate.

However, in the structure shown in Fig. 5, since the TCP 8 is provided with a slit for folding of the TCP, and the folding is carried out after the TCP 8 is connected in a flat state with the terminals of the display element 1 by thermocompression bonding, there is a problem that a margin 9 for folding over the TCP goes beyond the outer shape of the display device. resulting in larger overall size of the device.

Further, depending on the direction of the folding, the IC 4 and other electronic parts mounted on the film substrate are located between the film substrate and the display element. In that case, restriction with regard to the thickness of the whole film substrate increases in designing electronic equipment in which the display element is to be incorporated.

In the COF structure shown in Fig. 6, though the problem of parts location can be dealt with by a through hole; since the number of output electrodes of the driver IC 4 is large and the terminal connection pitch is fine, a through hole area 10 increases in size. This either decreases the parts mounted area or enlarges the outer shape of the film substrate, leading to increased design restriction.

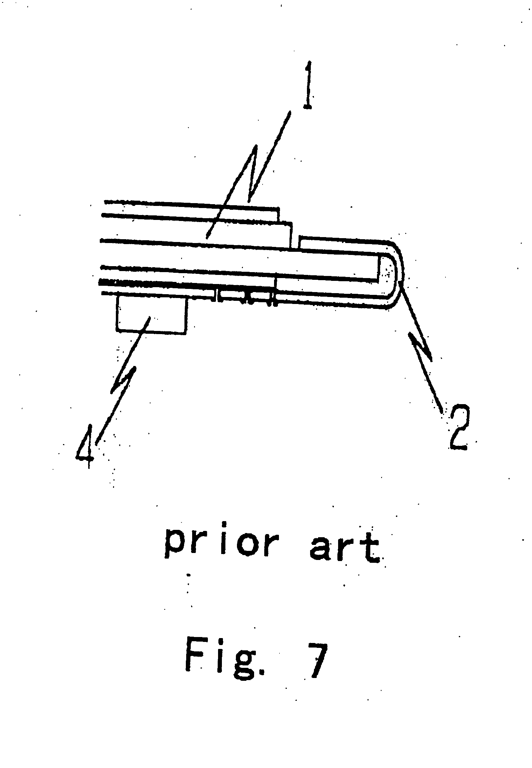

In the case where the connection between terminals of the film substrate and of the display element is structured as shown in Fig. 7, there arises design restrictions with regard to a margin for folding over the film 2 and with regard to the through hole area.

In the case where a COF formed of a single film substrate is connected with a display element whose terminals are disposed on respective transparent substrates facing each other, connection with one of the transparent substrates can be carried out, while connection with the other, facing transparent substrate is very difficult in a compression bonding process. Therefore, in this case, the COF must be prepared for the terminals of the respective transparent substrates forming the display element.

Further, though an I/F cable may be connected with a circuit substrate as a discrete part, in the case of a COF, the I/F cable is formed of an FPC itself so as to be T-shaped or L-shaped. Because of the shape, the number of the COFs which can be taken from the material is small.

US 5606440 discloses a method of assembly of a flat-type display device comprising a liquid crystal panel having electrode terminals on a peripheral portion of one face of the panel. A flexible wiring board having a drive IC is connected to the terminals and to a common wiring board for transmitting an input signal. The liquid crystal panel and the common wiring board are mounted on each other and the flexible wiring board is provided in a clearance between them.

Accordingly, objects of the present invention are to make smaller the size of the outer shape of a margin portion for folding over a film substrate, to realise a structure where a single film substrate can be easily connected with a plurality of sides of a display element, and to make larger the number of film substrates which can be taken from the material by improving the layout of I/F cables.

According to a first aspect of the present invention, there is provided a display device comprising a display element having a pair of transparent substrates and a liquid crystal material held therebetween, terminals of said display element being connected with a terminal portion of a film substrate, wherein said film substrate is located substantially at the side opposite the liquid crystal material of one of the transparent substrates and that said terminal portion of said film substrate is folded over with a spacer sandwiched therebetween for connection with said terminals of said display element located on the same side as the liquid crystal material of the other of the transparent substrates.

According to another aspect of the present invention, there is provided a method for manufacturing a display device comprising a display element with a film substrate, the display element having a pair of transparent substrates and a liquid crystal material therebetween, the method comprising the steps of:
folding a terminal portion of said film substrate;
disposing the film substrate substantially at the side opposite the liquid crystal material of one of the transparent substrates; and
bonding the folded terminal portion and terminals of said display element located at the same side as the liquid crystal material of the other of the transparent substrates, in order to electrically connect said display element with said film substrate.

Further, in the case that a display element having terminals on a plurality of edges of one side is used, the terminals are disposed on the respective edges on one side on one of the transparent substrates and the terminals of the film substrate are connected with the terminals on the respective edges.

Since the film substrate in a folded state is disposed on the inner shape side of the display element and the terminals of the film substrate are connected with the terminals of the display element, the margin for folding over the film substrate does not go beyond the outer shape of the display element, or, the amount of the margin for folding over the film substrate going beyond the outer shape of the display element is decreased, and thus, the outer shape of the display device can be made smaller.

Further, restriction with regard to the parts mounting area and the wiring layout can be eliminated and the surface of parts such as an IC can be located on the front surface.

In the case of a display element having terminals on its plurality of sides, since the terminals are provided on a plurality of adjacent sides of one of transparent substrates forming the display element, a single film substrate can be connected with the terminals on the plurality of sides, and thus, the number of parts can be reduced.

Further, since the I/F cable is formed by making a U-shaped cut in the film substrate, the number of film substrates which can be taken from the material becomes larger.

Embodiments of the present invention will now be described by way of further example only and with reference to the accompanying drawings, in which:-
Fig. 1 is a side elevation showing a schematic structure of a display device according to the present invention,
Fig. 2 is a side view showing a film substrate for use in the display device according to the present invention,
Fig. 3 is a perspective view showing a rear surface of a display device of a second embodiment according to the present invention,
Fig. 4 is a perspective view showing a rear surface of a liquid crystal display element of the second embodiment according to the present invention,
Fig. 5 is a side view showing a schematic structure of a conventional display device,
Fig. 6 is a side view showing a schematic structure of a conventional COF type display device, and
Fig. 7 is a side view showing a schematic structure of a conventional COF type display device with a folded-over portion.

### (Embodiment 1)

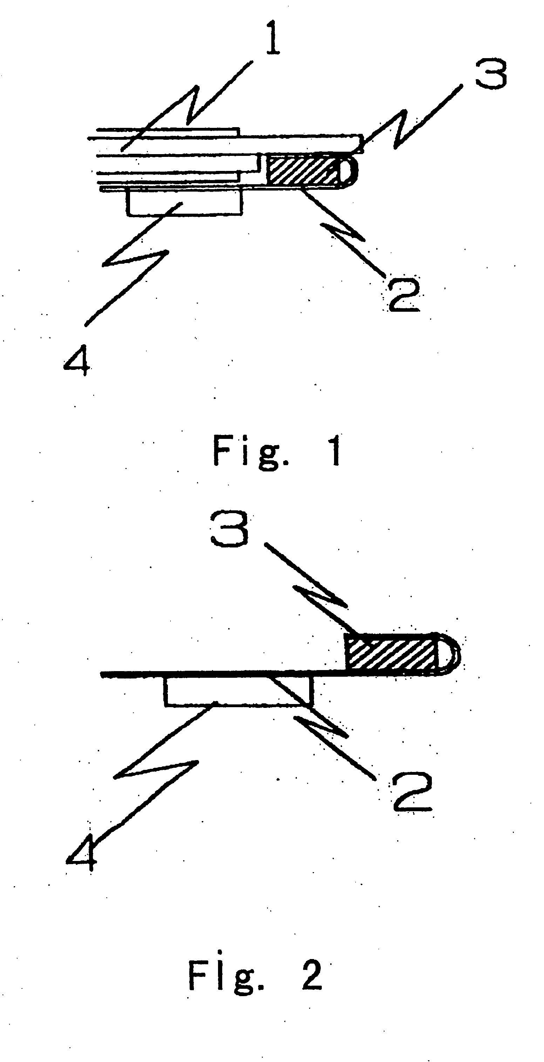

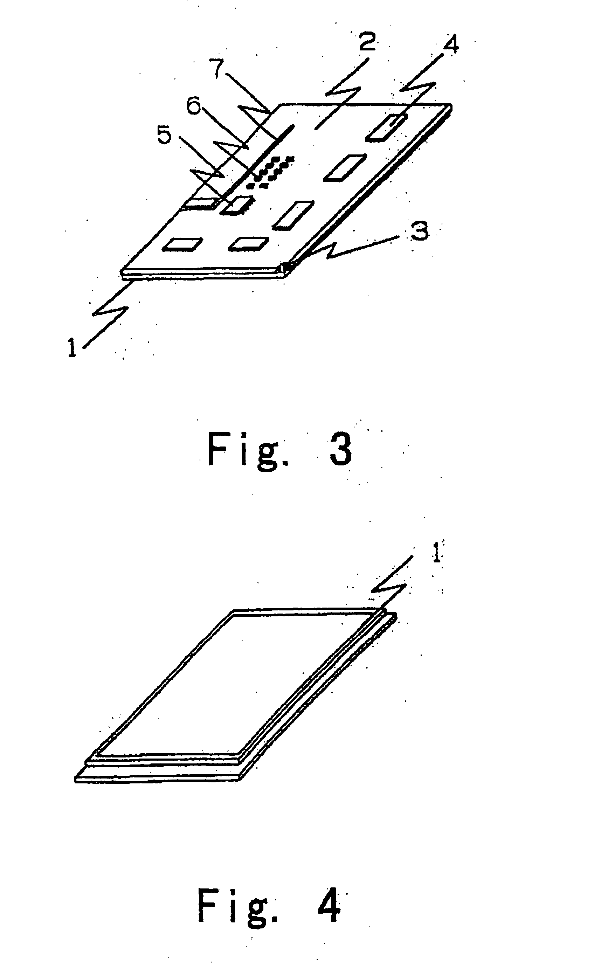

Fig. 1 is a side elevation showing a schematic structure of a display device according to the present invention. A display element 1 has glass substrates with a thickness of 0.5 mm and has transparent electrodes such as ITO electrodes formed thereon, facing each other with the patterned faces being on the inner sides of the substrates. A liquid crystal is encapsulated in the space between the glass substrates and a polarising plate is provided. Fig. 2 is a side view showing the state of a film substrate just before being mounted on the display element. A driver IC 4 is face down mounted with an anisotropic conductive film on a film substrate 2 formed by patterning Cu on a polyimide film having a thickness of 25 microns. Output signal electrodes of the drive IC are led to terminals for connection with the display element, and are in the state of being folded over with a spacer 3, made of silicone and having a Shore A hardness of about 70, sandwiched with adhesive therebetween.

The terminals of the film substrate and of the display element are thermocompression bonded via the anisotropic conductive film to carry out connection. Though thermocompression bonding is typically carried out from the side of the film substrate, in the illustrated arrangement it is carried out from the side of the glass surface. Compression bonding for 20 seconds with the temperature of a compression bonding head being set at 250°C and reaching a temperature of about 180°C is sufficient to carry out curing reliably.

The size of the outer shape of the display device according to the embodiment shown in Fig. 1 can be made smaller than that of a conventional structure by about 1.5 mm. However, the present invention is not limited to a structure in which a margin for folding over a film substrate is located inside the outer shape of the terminals of a display device. There is no particular problem even if the margin for folding over the film substrate goes beyond the outer shape of the device.

Treatment of the terminals of the film substrate is not limited to folding them over with a spacer sandwiched therebetween. They may be wound or may have any other structure which functions similarly to that of the present embodiment. The material of the spacer is selected according to the temperature and the conditions at which the spacer is compression bonded against the liquid crystal display device and so on.

The size of the film substrate is not limited to the above-mentioned one. Further, a TCP may also be used.

Still further, the film substrate may be made of PET. In this case, since PET is permeable to ultraviolet light, the film substrate may be directly connected with the IC using ultraviolet-light-curing contractive adhesive. Similarly, the display element and the film substrate may be directly connected with each other using ultraviolet-light-curing contractive adhesive. Also, in this case, when the connection is carried out via a conductor such as Ag, the reliability is further improved.

The connection between the terminals of the film substrate and of the liquid crystal display device may be carried out by pressure welding using a caulking metal frame without using the anisotropic conductive film or the ultraviolet-light-curing adhesive. In this case, replacement of the film substrate becomes easier.

### (Embodiment 2)

Fig. 3 is a perspective view of a second embodiment of the display device according to the present invention. Fig. 4 shows a display element 1 used in the second embodiment and is a perspective view seen from the rear side. Here, description is made of an STN type liquid crystal display element being used as the display element, by way of example. Electrodes of an upper transparent substrate, shown in Fig. 4, are connected with a terminal pattern provided on the side of a lower transparent substrate using a conductive agent disposed in the liquid crystal panel. Therefore, all terminals to be externally connected are provided on the lower transparent substrate.

A film substrate 2 (Fig. 3) is a double-sided wiring board and is formed by patterning Cu on both sides of a polyimide base having a thickness of 25 microns. It is provided with a through hole. In addition to a driver IC 4, an IC package 5 and chip parts 6 are connected with the film substrate 2 by soldering or the like.

The film substrate 2 and the display element 1 are connected in a similar way as in the first embodiment, and the connection is carried out with regard to the respective sides one by one in order.

Further, an I/F cable is formed by a part of the film substrate by making an L-shaped cut 7. Thus, the number of film substrates which can be taken from the material can be made larger.

In the case of a PET substrate being used, in order to mount thereon the IC package and the chip parts, by using Ag paste or Bi/Sn series soldering as the material, connection at 150°C or lower can be carried out to avoid deformation.

As described above, according to the present invention, a miniaturised, compact display device can be provided. Further, in the case of a film substrate being mounted on a plurality of sides of a liquid crystal display element, by reducing the number of parts, in addition to the above-mentioned effect, an inexpensive display device can be provided.

## Claims

1. A display device comprising a display element (1) having a pair of transparent substrates and a liquid crystal material held therebetween, terminals of said display element being connected with a terminal portion of a film substrate (2), **characterised in that** said film substrate (2) is located substantially at the side opposite the liquid crystal material of one of the transparent substrates and that said terminal portion of said film substrate (2) is folded over with a spacer (3) sandwiched therebetween for connection with said terminals of said display element (1) located on the same side as the liquid crystal material of the other of the transparent substrates.

2. A display device as claimed in claim 1, **characterised in that** the film substrate comprises a single central portion disposed on said side opposite the liquid crystal material, that said terminals of said display element are disposed on a plurality of edges of said same side as the liquid crystal material and that said terminal portion of said film substrate is connected at said plurality of edges.

3. A method for manufacturing a display device comprising a display element (1) with a film substrate (2), the display element having a pair of transparent substrates and a liquid crystal material therebetween, the method comprising the steps of:
folding a terminal portion of said film substrate;
disposing the film substrate substantially at the side opposite the liquid crystal material of one of the transparent substrates; and
bonding the folded terminal portion and terminals of said display element located at the same side as the liquid crystal material of the other of the transparent substrates, in order to electrically connect said display element with said film substrate.

4. A method for manufacturing a display device according to claim 3, **characterised in that** said terminal portion of said film substrate is folded with a spacer (3).

5. A method for manufacturing a display device according to claim 3 or claim 4, **characterised in that** said terminal portion of said film substrate is connected with said terminals of said display element via an anisotropic conductive film, and further comprising a step of thermocompression bonding from a side of said display element.

## Patentansprüche

1. Anzeigeeinrichtung, umfassend ein Anzeigeelement (1) mit einem Paar von transparenten Substraten und einem dazwischen gehaltenen Flüssigkristallmaterial, wobei Anschlüsse des Anzeigeelements mit einem Anschlussabschnitt eines Filmsubstrats (2) verbunden sind, **dadurch gekennzeichnet, dass** das Filmsubstrat (2) im Wesentlichen an der dem Flüssigkristallmaterial entgegengesetzten Seite eines der transparenten Substrate angeordnet ist und dass der Anschlussabschnitt des Filmsubstrats (2) mit einem dazwischen eingefügten Abstandhalter (3) umgefaltet ist für eine Verbindung mit den Anschlüssen des Anzeigeelements (1), angeordnet auf der gleichen Seite wie das Flüssigkristallmaterial des anderen der transparenten Substrate.

2. Anzeigeeinrichtung nach Anspruch 1, **dadurch gekennzeichnet, dass** das Filmsubstrat einen einzigen Zentralabschnitt umfasst, der an der dem Flüssigkristallmaterial entgegengesetzten Seite angeordnet ist, dass die Anschlüsse des Anzeigeelements an einer Mehrzahl von Kanten der gleichen Seite wie das Flüssigkristallmaterial angeordnet sind und dass der Anschlussabschnitt des Filmsubstrats an der Mehrzahl von Kanten verbunden ist.

3. Verfahren zum Herstellen einer Anzeigeeinrichtung umfassend ein Anzeigeelement (1) mit einem Filmsubstrat (2), wobei das Anzeigeelement ein Paar von transparenten Substraten und ein Flüssigkristallmaterial dazwischen aufweist, wobei das Verfahren die Schritte umfasst:
Falten eines Anschlussabschnitts des Filmsubstrats,
Anordnen des Filmsubstrats im Wesentlichen an der dem Flüssigkristallmaterial entgegengesetzten Seite eines der transparenten Substrate, und
Zusammenschließen des gefalteten Anschlussabschnitts mit Anschlüssen des Anzeigeelements, angeordnet auf der gleichen Seite wie das Flüssigkristallmaterial des anderen der transparenten Substrate, um das Anzeigeelement mit dem Filmsubstrat elektrisch zu verbinden.

4. Verfahren zum Herstellen einer Anzeigeeinrichtung nach Anspruch 3, **dadurch gekennzeichnet, dass** der Anschlussabschnitt des Filmsubstrats mit einem Abstandhalter (3) gefaltet wird.

5. Verfahren zum Herstellen einer Anzeigeeinrichtung nach Anspruch 3 oder Anspruch 4, **dadurch gekennzeichnet, dass** der Anschlussabschnitt des Filmsubstrats über einen anisotropen leitfähigen Film mit den Anschlüssen des Anzeigeelements verbunden wird, und ferner umfassend einen Schritt eines Thermokompressionszusammenschlusses von einer Seite des Anzeigeelements.

## Revendications

1. Dispositif d'affichage comprenant un élément d'affichage (1) ayant une paire de substrats transparents entre lesquels un matériau à cristaux liquides est maintenu, les bornes dudit élément d'affichage étant raccordées à une partie terminale d'un substrat de type film (2), **caractérisé en ce que** ledit substrat de type film (2) se trouve sensiblement du côté opposé au matériau à cristaux liquides de l'un des substrats transparents et **en ce que** ladite partie terminale dudit substrat de type film (2) est repliée en prenant en sandwich une entretoise (3) pour un raccordement auxdites bornes dudit élément d'affichage ( 1) situé du même côté que le matériau à cristaux liquide de l'autre des substrats transparents.

2. Dispositif d'affichage selon la revendication 1, **caractérisé en ce que** le substrat de type film comprend une partie centrale unique disposée dudit côté opposé au matériau à cristaux liquides, **en ce que** lesdites bornes dudit élément d'affichage sont disposées sur une pluralité de bords dudit même côté que le matériau à cristaux liquides et **en ce que** ladite partie terminale dudit substrat de type film est raccordée à ladite pluralité de bords.

3. Procédé de fabrication d'un dispositif d'affichage comprenant un élément d'affichage (1) avec un substrat de type film (2), l'élément d'affichage ayant une paire de substrats transparents entre lesquels se trouve un matériau à cristaux liquides, le procédé comprenant les étapes consistant à :
replier une partie terminale dudit substrat de type film ;
disposer le substrat de type film sensiblement du côté opposé au matériau à cristaux liquides de l'un des substrats transparents ; et
lier la partie terminale repliée et les bornes dudit élément d'affichage situées du même côté que le matériau à cristaux liquides de l'autre des substrats transparents, afin de raccorder électriquement ledit élément d'affichage audit substrat de type film.

4. Procédé de fabrication d'un dispositif d'affichage selon la revendication 3, **caractérisé en ce que** ladite partie terminale dudit substrat de type film est repliée avec une entretoise (3).

5. Procédé de fabrication d'un dispositif d'affichage selon la revendication 3 ou la revendication 4, **caractérisé en ce que** ladite partie terminale dudit substrat de type film est raccordée auxdites bornes dudit élément d'affichage via un film conducteur anisotrope, et comprenant en outre une étape de soudage par thermocompression depuis un côté dudit élément d'affichage.
